(19) Europäisches Patentamt / European Patent Office / Office européen des brevets

(11) **EP 1 803 217 B1**

(12) **EUROPEAN PATENT SPECIFICATION**

(45) Date of publication and mention
of the grant of the patent:
**16.07.2008   Bulletin 2008/29**

(51) Int Cl.:
*H03D 7/16* (2006.01)       *H04H 1/00* (2008.01)

(21) Application number: **05857337.9**

(86) International application number:
**PCT/GB2005/050151**

(22) Date of filing: **12.09.2005**

(87) International publication number:
**WO 2006/087506 (24.08.2006 Gazette 2006/34)**

(54) **Local oscillator circuit for a multiband digital audio broadcast receiver**

Empfängeroszillatorschaltung für digitalen Multiband-Audiorundfunkempfänger

Circuit d'un oscillateur locale pour un récepteur de radiodiffusion numérique multibande

(84) Designated Contracting States:
**AT BE BG CH CY CZ DE DK EE ES FI FR GB GR
HU IE IS IT LI LT LU LV MC NL PL PT RO SE SI
SK TR**

(30) Priority:  **20.09.2004  GB 0420843**

(43) Date of publication of application:
**04.07.2007   Bulletin 2007/27**

(73) Proprietor: **Frontier Silicon Limited
Cambridge
Cambridgeshire CB2 4LJ (GB)**

(72) Inventors:
• **LUFF, Gwilym Francis,**
**c/o Frontier Silicon Limited
Cambridge,
Cambridgeshire CB2 4LJ (GB)**

• **TROOP, Nicholas Mark,**
**c/o Frontier Silicon Limited
Cambridge Cambridgeshire CB2 4LJ (GB)**
• **TUNCER, Sencan,**
**c/o Frontier Silicon Limited
Cambridge,
Cambridgeshire CB2 4LJ (GB)**
• **EDDOWES, David,**
**c/o Frontier Silicon Limited
Cambridge,
Cambridgeshire CB2 4LJ (GB)**

(74) Representative: **Martin, Philip John
Marks & Clerk
62-68 Hills Road
Cambridge CB2 1LA (GB)**

(56) References cited:
**EP-A- 0 896 425           US-A- 5 630 214**

**Description**

This invention relates to improved architectures for digital audio broadcast (DAB) receivers, in particular multi-band DAB receivers.

Background information on digital audio broadcast service standards can be found in the EUREKA-147 standard (ETSI Document EN300 401 V1.3.3 (2001-5); reference may also be made to BS EN 50248.2001. Digital audio broadcast services are currently provided in two frequency bands, 174 - 240 MHz (Band 3 in the UK) and 1452 - 1492 MHz (L Band) for the rest of the world; it is also useful for a DAB receiver to be capable of receiving conventional FM (Frequency Modulation) broadcasts, in the UK at 88 - 108MHz.

It is desirable to be able to provide a radio receiver circuit which is usable in both the present DAB frequency bands and preferably also for receiving conventional FM broadcasts. Preferably such a radio receiver circuit would be suitable for single chip integration so that a single integrated circuit may be provided for constructing a receiver for use with any of the presently envisaged DAB broadcast standards. In order to achieve this it is desirable to be able to provide a multiple band, tunable DAB receiver which operates over a wide frequency range.

EP-A-896425 discloses a local oscillator circuit for a digital audio broadcast receiver, receiving RF-signals in 2 frequency bands; comprising a PPL including a tunable VCO and a divider to provide a local oscillator signal output.

According to a first aspect of the present invention there is therefore provided a digital audio broadcast (DAB) receiver, the receiver comprising: an rf input to receive rf signals in at least two receive frequency bands; a local oscillator having a local oscillator signal output; a mixer having inputs coupled to said rf input and to said local oscillator and having an output to provide an IF frequency signal; and an output to provide an output signal from said IF frequency signal; and wherein said local oscillator comprises a phase locked loop (PLL) including a tunable voltage controlled oscillator (VCO) and a programmable divider coupled to an output of said voltage controlled oscillator to provide said local oscillator signal output; at least one of said two receive frequency bands being associated with a plurality of different division ratios of said programmable divider; wherein said voltage controlled oscillator (VCO) has a plurality of selectable VCO frequency bands; and wherein said local oscillator further comprises a VCO band selector to select a said VCO frequency band; whereby said at least two receive frequency bands are covered by said receiver by a combination of said VCO band selection and said plurality of different division ratios.

Preferably the at least two frequency bands comprise a first frequency band of frequencies greater than 1GHz, and a second frequency band in the range 100MHz to 1 GHz; more particularly preferably the at least two frequency bands comprise the above mentioned DAB broadcast bands. Further preferably the receiver is configured to receive a conventional FM (frequency modulation) broadcast in a third band by employing a combination of VCO band selection and a plurality of different division ratios.

In preferred embodiments the VCO uses a diode or junction varactor for tuning the VCO responsive to a control voltage, and a plurality of MOS (metal oxide semiconductor) varactors for selection of a frequency band for the VCO. This is because a MOS varactor can readily be switched between low and high capacitance values, thus facilitating large frequency changes for band selection, the use of a junction varactor for tuning facilitating tuning control of the oscillator. In a preferred embodiment band selection is performed by a plurality of MOS varactors with binary weighted varactor areas so that combinations of these may be selected for the selection of intermediate frequency bands. Preferably the VCO frequency bands overlap to facilitate compensation for temperature and supply voltage changes, and component tolerances.

The use of a multi-band VCO can cause phase locked loop control difficulties because, in general, the VCO sensitivity (that is change in output frequency with control voltage) will be different in the different frequency bands. This case lead to variations in lock time, phase noise, stability and reference-energy suppression performance. Preferably, therefore, the phase locked loop has a control loop in which the loop gain is adjusted dependent upon the frequency band selected for the VCO and/or the VCO tuning voltage. A controllable gain element may be included in the loop but in a preferred embodiment the PLL phase detector comprises a charge pump with feedback from the current output to a pump current adjust input (to vary the pump output with VCO tuning voltage) and/or a selectable plurality of current generators (sources and/or sinks) so that one or more of these can be selected in accordance with the frequency band selected for the VCO. In this latter case preferably a band-switching control system is included comprising a voltage comparator to sense the VCO control voltage and switch bands if this is outside one or more limits for greater than a predetermined time threshold (to avoid instabilities). In preferred embodiments the receiver is integrated onto a single chip.

The invention also provides a local oscillator, as described above, for this DAB receiver.

These and other aspects of the present invention will now be further described, by way of example only, with reference to the accompanying figures in which:

Figure 1 shows a block diagram of a DAB radio receiver circuit embodying aspects of the present invention;

Figure 2 shows a block diagram of a multi-band voltage controlled oscillator for use in preferred embodiments of the present invention;

Figures 3a and 3b show curves of capacitance against bias voltage for, respectively, a junction varactor, and a MOS varactor;

Figure 4 shows a set of curves of VCO sensitivity (Kvco) against output frequency of the VCO for the VCO of figure 2 when operating in each of its eight frequency bands;

Figures 5a and 5b show, respectively, a block diagram of a divide-by-N phase locked loop (PLL), and linearised model of the PLL of figure 5a;

Figure 6 shows an example of a phase locked loop circuit for use in preferred embodiments of the present invention;

Figure 7 shows an example of a phase detection system incorporating a charge pump for use in embodiments of the present invention;

Figure 8 shows a second example of a phase detection system incorporating an alternative charge pump for use in embodiments of the present invention; and

Figure 9 shows a block diagram of a complete DAB receiver 900 incorporating the radio receiver circuit of Figure 1.

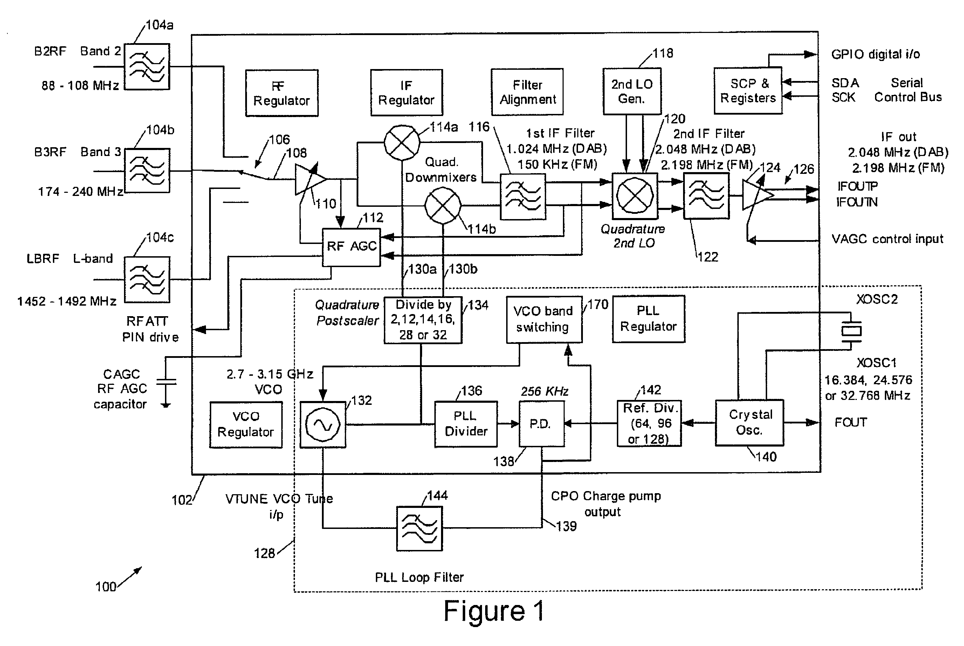

Referring first to figure 1, this shows a block diagram of a radio receiver circuit, up to an IF output stage (IFOUT). This will generally be followed by analogue-to-digital converter (ADC) and digital signal processing (not shown) for final conversion down to base band and demodulation. In the receiver 100 of figure 1 the circuitry enclosed by solid line 102 is preferably provided on an integrated circuit.

The signal paths begin with off-chip band select filters 104a, b, c, for DAB signals in Band 3 and L-band and FM broadcast signals in Band 2; these may receive their inputs from a single, shared antenna, or from multiple antennas (not shown). These band select filters provide an input 108 into an on-chip variable gain low noise amplifier (LNA) 110; typically band selection information from base band processing circuitry determines which RF input is selected by multiplexer 106 for input into this amplifier. The output of LNA 110 is provided to an RF AGC circuit 112, and also to a quadrature down conversion mixer 114a, b, followed by a polyphase filter 116. Receiver 100 operates as a near zero IF receiver and thus the DAB input signal (which has a bandwidth of approximately 1.536MHz) is down converted to a first IF frequency of 1.024MHz. A preferred IF frequency plan employs down conversion to a first IF frequency followed by up conversion to a second higher IF frequency, and this is implemented by local oscillator 118 and second quadrature mixers 120, which are followed by low pass filter 122 and variable gain output buffer 124 which provides a differential output (IFOUT) 126. Although not shown as such, for clarity, preferably all the signal paths in integrated circuit 102 are differential, including RF, local oscillator, and IF signals.

A frequency plan for the receiver of figure 1 is shown in table 1 below. This frequency plan demonstrates high-side injection of the first LO (that is, with the local oscillator frequency greater than that of the target RF signal, $f_{LO} = f_{RF} + f_{IF}$). Low side injection (with the local oscillator frequency less than that of the target RF signal, $f_{LO} = f_{RF} - f_{IF}$) is also possible with this architecture.

**Table 1**

| Frequency plan for DAB and FM modes of operation | |
|---|---|
| RF input | DAB: 170 - 240 MHz or 1452 - 1492 MHz<br>FM: 88-108MHz, |
| First local oscillator frequency | DAB: RF frequency + 1.024 MHz<br>FM: RF frequency+150 kHz |
| First IF frequency | DAB: 1.024 MHz; FM: 150kHz |
| Second local oscillator frequency | DAB: 1.024 MHz; FM: 2.048 MHz |
| Second IF frequency | DAB: 2.048 MHz; FM: 2.198MHz |

From table 1 it can be seen that the first local oscillator frequency must be controlled over a wide range. In the receiver 100 of figure 1 this first local oscillator is implemented by the circuitry within dashed line 128, this providing a quadrature output 130a, b to respective quadrature down conversion mixers 114a, b. This first oscillator circuit, which embodies aspects of the present invention, is described further below. However, to facilitate understanding of the invention, operation of the receiver of figure 1 will first be briefly outlined.

As previously described, the IF after downconversion is 1.024MHz for the DAB inputs (Band 3, L-Band); I is 150KHz for the FM input (Band 2). After polyphase filtering the signal is upconverted to 2.048MHz for DAB and 2.198MHz for FM, and an IF variable gain amplifier and output driver provides a differential ADC drive for a subsequent base-band IC (not shown in figure 1). A PLL with on-chip LC VCO and a post divider generates the first LO signal for all bands and this PLL, the second LO generation and the filter alignment are all referenced to the crystal reference frequency (of 16.384, 24.576 or 32.768MHz)

There are three LNA inputs, one for each frequency band. Each LNA has 40dB of AGC control range, and a P1dB of-15dBm. Without external AGC components the chip can meet the -25dBm high level input requirements for portable receivers; an off-chip PIN diode attenuator may be used to extend the input range to -15 or -10 dBm. The RF input filters may provide protection for ESD discharges to an external antenna.

The IF filters combine the functions of channel selectivity, anti-alias filtering for the baseband ADC and quadrature combining for image rejection. The first IF filter is a four-pole bandpass filter centred at 1.024mHz, with 3dB bandwidth of 1.9MHz to 270kHz. After the quadrature upconversion to the second IF, additional filtering is used to prevent aliasing. This is achieve with the second IF filter, which has an upper frequency of 2.048MHz and a bandwidth of 3.6MHz. A filter alignment circuit may be used to align the centre frequency and bandwidth of all IF filters to the crystal reference frequency. A calibration cycle may be run each time the PLL is re-programmed, or when the PLL or IF circuits are turned on. Periodically, say every half second, an on die temperature sensor may be employed to take a reading and update the filter tuning.

A first AGC loop controls the RF AGC amplifier and the (optional) external PIN diode attenuator to avoid overloading of the RF and IF circuits; this detects signal levels at the first mixer input and at the first IF filter output. The IF AGC amplifier provides the final gain at the second IF. This is preferably controlled by the baseband IC to give a constant input level to the ADC on the baseband chip.

In a preferred implementation the frequency synthesiser includes an integer-N PLL comprising a fully integrated VCO, prescaler, phase detector, charge pump, reference divider and reference prescaler; and the loop filter is external. The reference divider divides down an externally provided reference frequency to a comparison frequency of 256kHz for all bands. The VCO output is divided by 2 for L-Band, or by 12, 14 or 16 for Band 3 and by 28 or 32 for Band 2. The quadrature output of this programmable divider feeds the quadrature downmixers. This results in a first IF frequency of 1.024MHz for all DAB bands (IF$_{DAB}$), and 150KHz for Band 2 FM mode. The second LO of 1.024MHz (DAB mode) or 2.048MHz (FM mode) for the upconverter is divided down from the reference frequency. This results in a second IF frequency of 2.048MHz for DAB and 2.198MHz for FM mode. The PLL and post-divider provide a channel frequency resolution of 64 KHz for L-band and Band 3, and a 4 KHz resolution for fine tuning in Band 2.

Referring again to figure 1, the local oscillator frequency synthesiser 128 employs an integer-N phase locked loop comprising a voltage controlled oscillator 132 providing an output to a postscaler 134 providing the quadrature outputs 130a,b, and phase locked loop (PLL) divider 136 also coupled to the output of VCO 132 and providing an output to a phase detector 138 comprising a charge pump (not shown in figure 1). Phase detector 138 also receives an input from a crystal oscillator 140 via a reference divider 142 as follows the phase detector 138 provides a charged pump output 139 to an external PLL low pass loop filter 144, the output of which provides a VCO tuning voltage (frequency control signal) to the VCO 132. in preferred arrangements the reference divider divides down a reference frequency from crystal oscillator 140 (which uses an external crystal) to a comparison frequency of 256KHz for all the three bands. A PLL resolution of 0.5 counts allows the VCO to be tuned in 128KHz steps.

Referring now to the programmable post-divider 134, table 2 below shows the first local oscillator frequencies which are employed to obtain the desired first IF frequencies for DAB and FM modes, with high-side injection (that is with the local oscillator frequency greater than that of the target RF signal).

**Table 2**

| Mode | Band | RF Frequency | First LO frequency | First IF Frequency |
|------|------|--------------|--------------------|--------------------|
| FM | Band 2 | 88-108MHz | 88.15-108.15MHz | 150kHz |
| DAB | Band 3 | 174-240MHz | 175.024-241.024MHz | 1.024MHz |
| DAB | L-Band | 1452-1492MHz | 1453.024-1493.024MHz | 1.024MHz |

To produce these local oscillator (LO) frequencies using a single integrated VCO, the output frequency of VCO 132 is chosen to be at a higher frequency than the required LO frequencies, and programmable divider 134 reduces the VCO output frequency as needed. As previously described the quadrature output 130 of programmable divider 134 feeds the quadrature downmixers 114.

The output of VCO 132 is divided by 2 for L-band; by 12, 14 or 16 for Band 3; and by 28 or 32 for Band 2. Different division ratios for a single band are thus used to cover sections of the band, thus reducing the VCO tuning range requirements. In this way the VCO 132 need only run from 2.7GHz to 3.15GHz.

Table 3a below shows band breaks selected according to this plan to reduce frequency range requirements. The actual band edges are the band limits that can be achieved when the programmable divider settings are as given in Table 3b (below), with the VCO 132 running from 2.7GHz to 3.15GHz. Table 3b also shows the frequency limits of VCO 132 required to cover all the band breaks (where the LO frequency is achieved by dividing the frequency of VCO 132 with the programmable divider 134). With this plan the PLL and post-divider 134 provide a channel frequency resolution of 64 KHz for L-band and Band 3, and a 4 KHz resolution for fine tuning in Band 2.

**Table 3a**

| Frequency Bands | section | Nominal Band Edges (MHz) | | Actual Band Edges (MHz) | |
|---|---|---|---|---|---|
| | | lower | upper | lower | upper |
| L Band | 1 band | 1452 | 1492 | 1348.976 | 1573.976 |
| Band 3 breaks (nominal) | lower | 174 | 194 | 167.726 | 195.851 |
| | mid | 194 | 224 | 191.8331 | 223.976 |
| | upper | 224 | 240 | 223.976 | 261.476 |
| Band 2 breaks (nominal) | lower | 86 | 97 | 84.225 | 98.2875 |
| | mid | 97 | 108 | 96.27857 | 112.35 |

**Table 3b**

| IF | | | |
|---|---|---|---|
| Low IF | -1.024 | MHz | DAB mode |
| | -0.15 | MHz | FM Mode |

| VCO | lower | upper | |
|---|---|---|---|
| VCO Frequency | 2700 | 3150 | MHz |

| Operation mode | Band section | VCO frequency (MHz) | | Divider setting | Channel Frequency resolution | | | 1st LO frequency (MHz) | |
|---|---|---|---|---|---|---|---|---|---|
| | | lower | upper | | | | | lower | upper |
| L band | 1 band | 2906.048 | 2986.048 | 2 | 64 | kHz | | 1453.024 | 1493.024 |
| Band 3 | lower | 2800.384 | 3120.384 | 16 | 8 | kHz | (64/8) | 175.024 | 195.024 |
| | mid | 2730.336 | 3150.336 | 14 | 9.14 | kHz | (64/7) | 195.024 | 225.024 |
| | upper | 2700.288 | 2892.288 | 12 | 10.67 | kHz | (64/6) | 225.024 | 241.024 |
| Band 2 | lower | 2756.8 | 3136.768 | 32 | 4 | kHz | (64/16) | 86.15 | 98.024 |
| | mid | 2720.2 | 3052.672 | 28 | 4.57 | kHz | (64/14) | 97.15 | 109.024 |

Again, the reference to negative low-IF frequencies implies high-side injection but, as previously mentioned, low-side injection (positive low-IF frequencies) can equally well be employed.

It is a design aim of the frequency synthesiser that the VCO 132 covers the frequency range of 2.7GHz to 3.15GHz under a range of temperature and supply voltage conditions, as well as component value variations. For this reason the actual VCO tuning range is chosen to be wider than 2.7 - 3.15GHz.

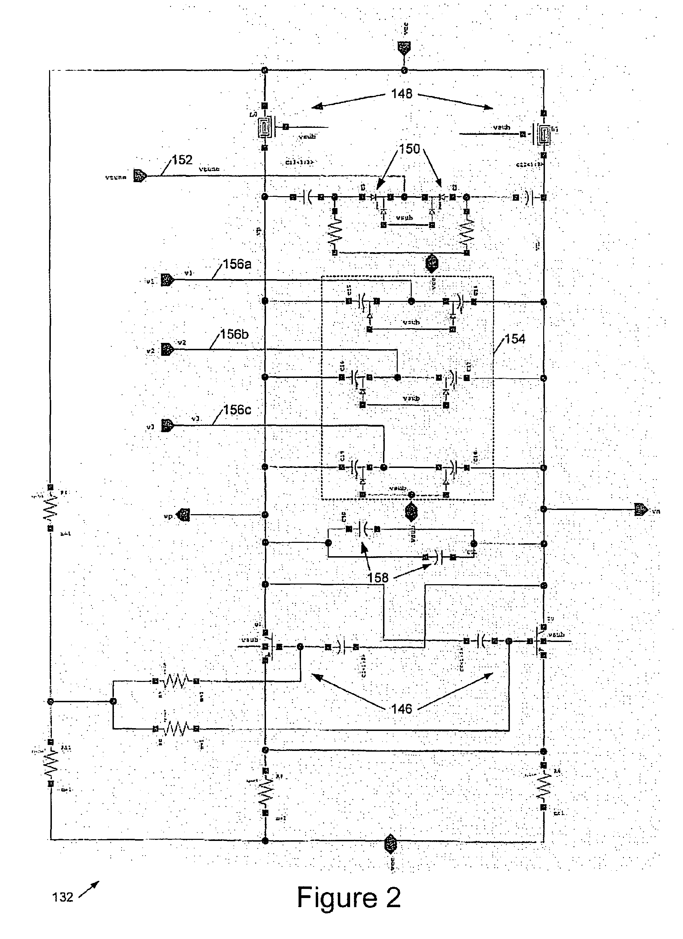

Figure 2 shows a preferred embodiment of VCO 132. Broadly speaking a symmetric VCO topology is employed, using a pair of cross-coupled MOS for bipolar transistors 146 with inductors 148 in their respective collector (or drain) circuits. Junction (or diode) varactors 150 are connected across inductors 148 to provide an adjustable capacitance controlled by a voltage on tuning voltage input 152. A set of MOS varactors shown inside dashed line 154 is also connected across inductors 148, in parallel with junction varactors 150, to provide band selection. Three pairs of MOS varactors are provided, each controlled by a respective band selection control voltage 156a, b, c. The capacitance presented by the MOS varactors 154 and the junction varactors 150, together with the fixed inductors 148 and fixed capacitors 158, determine the frequency of operation of VCO 132.

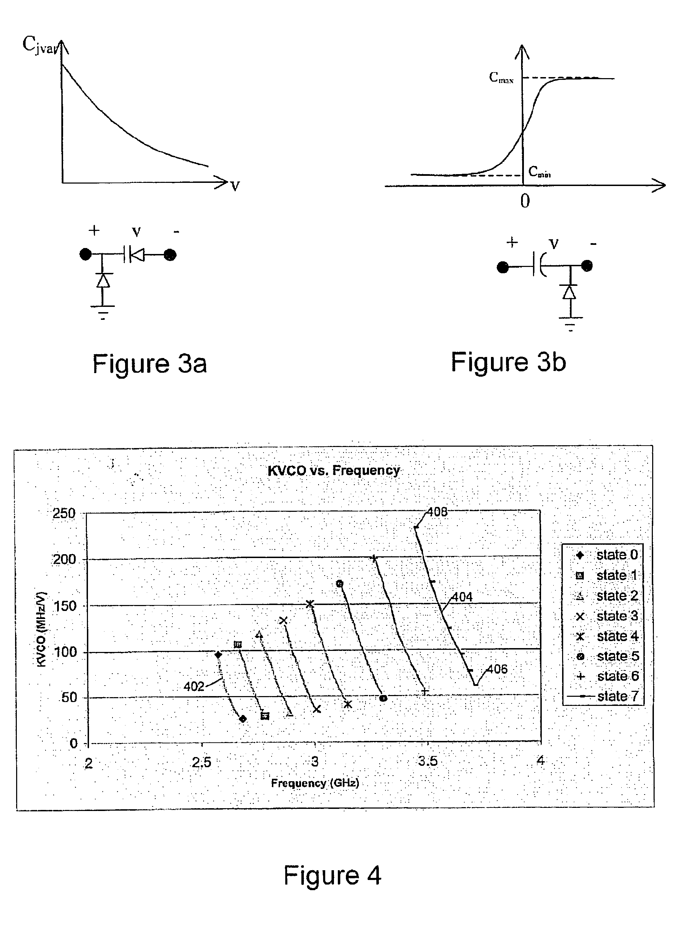

Figures 3a and 3b show circuit symbols and graphs of capacitance against bias voltage for a junction varactor and for an MOS varactor respectively. Referring to Figure 3 it can be seen that the MOS varactors 154 are characterized by a rapid change in capacitance with applied voltage, whereas the junction varactor 150 has a more gradual slope. The MOS varactors 154 are biased so that the band-switching control signals 156a-c can switch them between their Cmax and Cmin values. The MOS varactor areas are binary weighted, so three control signals cover eight ($2^3$) frequency ranges. When all the control signals are low the MOS varactors 154 contribute their maximum capacitance. This allows the junction varactor 150 to cover the lowest frequency section of the desired 2.7-3.15GHz range. When all control signals are high the MOS varactors 154 are at their minimum capacitance setting (highest VCO frequency range).

Table 4 (below) shows typical frequency ranges (that is tuning ranges) at which the VCO operates, for a set of band-switching control signal levels. The combination of the tune voltage and the band-switching signals allow this VCO to cover 2.577GHz to 3.705GHz under typical conditions. This range is large enough to ensure that the VCO can tune between 2.7GHz and 3.15GHz under a wide range of operating conditions. The band-switching ranges preferably overlap to avoid dead zones, that is frequency ranges to which the VCO cannot tune.

**Table 4**

| State | $V_3$ | $V_2$ | $V_1$ | VCO frequency for Vtune=0.2V (GHz) | VCO frequency for Vtune=2.5V (GHz) |
|---|---|---|---|---|---|
| 0 | Low | Low | Low | 2.577 | 2.683 |
| 1 | Low | Low | High | 2.663 | 2.780 |
| 2 | Low | High | Low | 2.757 | 2.888 |
| 3 | Low | High | High | 2.863 | 3.009 |
| 4 | High | Low | Low | 2.982 | 3.149 |
| 5 | High | Low | High | 3.116 | 3.307 |
| 6 | High | High | Low | 3.269 | 3.489 |
| 7 | High | High | High | 3.447 | 3.705 |

The large tuning range of the VCO, together with the band-switching, causes a large variation of the VCO sensitivity ($K_{VCO}$). Here Kvco is the change of the VCO frequency with the tune voltage (vtune); this varies with the band-switching state and with vtune. For a given band-switching state the sensitivity is higher for lower vtune levels, since the junction capacitance varies more rapidly at low bias voltages. For a given vtune, a lower band-switching state will have lower $K_{VCO}$, since the total capacitance in the resonator is higher, and a change in the junction varactor capacitance will therefore have less effect.

Figure 4 shows a set of curves of $K_{VCO}$ against frequency for the eight band-switching states. Referring to Figure 4, it can be seen that there is a general trend for the VCO sensitivity to increase as the band select control voltages are altered to move from a low frequency band (state 0, curve 402) to a high frequency band (state 7, curve 404). Likewise, referring for example to curve 404, the lower end 406 of this curve corresponds to a tuning voltage of 2.5V whereas the upper end 408 of this curve corresponds to a tuning voltage of 0.2V, from which it can be seen that there is a significant change in VCO sensitivity with VCO tuning voltage.

We will next describe techniques which can be employed to address drawbacks associated with this change in VCO sensitivity with selected VCO band, and also with VCO tuning. However it is first useful to briefly review phase lock loop operation.

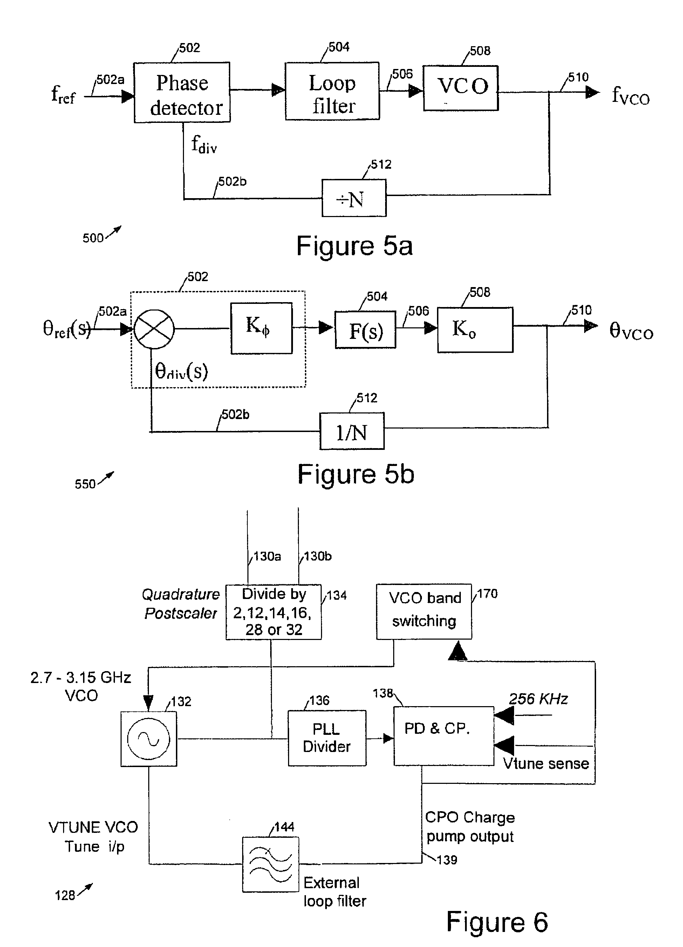

Referring to figure 5a, this shows a block diagram of a typical integer-N phase locked loop 500. This comprises a phase detector 502 which receives a first input 502a from a reference frequency source and a second input 502b from a divided down output of the phase locked loop. The phase detector 502 provides an output to a loop filter 504, the output of the loop filter providing a control voltage 506 for VCO 508 which provides an output 510 for the phase locked loop circuit, and which also provides an input to a divide-by-N circuit 512 the output of which provides frequency divided input 502b to phase detector 502.

Figure 5b shows a linearised model 550 of the phase detector 500 of figure 5a in which, broadly speaking, like elements are indicated by like reference numerals.

In the model of figure 5b:

$\theta_{ref}(s)$ is the phase of the reference signal;
$\theta_{VCO}(s)$ is the phase of the VCO signal;
$\theta_{div}(s)$ is the phase of the divided VCO signal;
$K_o$ is the VCO sensitivity in radians/second/volt ($K_o=2\pi K_{VCO}$);
$K_\phi$ is the phase detector gain in volts/radian
$F(s)$ is the loop filter transfer function;
$N$ is the PLL divider ratio.

With this model, the transfer function relating $\theta_{ref}(s)$ and $\theta_{VCO}(s)$ is:

$$B(s) = \frac{\theta_{vco}(s)}{\theta_{ref}(s)} \approx \frac{K_\phi K_o F(s)/s}{1 + K_\phi K_o F(s)/Ns} \qquad [\text{Equation 1}]$$

Further details of this and other PLL models can be found in, for example, Ulrich L. Rohde, David P. Newkirk; "RF/Microwave Circuit design for Wireless Applications", Wiley-Interscience, 2000, pp. 848-876.

From equation 1 it can be seen that the loop gain is dependent on the product of the phase detector gain, the VCO sensitivity and the loop filter transfer function. As previously explained, in the wide-range PLL circuit we describe the variation of the VCO sensitivity with tune voltage and band-switching state is high, and without additional measures this would cause changes in the loop gain. For a loop filter with a given bandwidth, changes in loop gain will lead to variations in lock time, phase noise, stability and reference-energy suppression performance, and it is therefore highly desirable to mitigate these effects.

Preferred embodiments of the techniques we employ to mitigate these effects use a phase detection system incorporating a charge pump, and it is therefore useful to review the operation of such a system.

As is well known to the skilled person, in such a system a phase (and frequency) detector generally comprises a sequential digital circuit which is treated by the edges of the divided down VCO frequency and reference frequency, the phase detector producing an "up" or a "down" output depending upon the relative timing of these edges. These outputs drive a charge pump which delivers a positive or negative (or zero) output current to the PLL loop filter. The loop filter generally comprises a low pass filter such as a series connected resistor and capacitor which converts the pump current to an analogue voltage for tuning the VCO.

Returning now to Equation 1, the loop dynamics are a function of the product of $K_{VCO}$ and $K_\phi$, and $K_\phi$ is proportional to charge pump output current. The inventor has recognised that the desired aim of making the PLL loop gain substantially constant can be achieved by varying the charge pump current with vtune and the band-switching state.

Considering first $K_{VCO}$, for a given band-switching state, $K_{VCO}$ is approximately inversely proportional to the tune voltage and the charge pump current should therefore be substantially proportional to the tuning voltage. This can be achieved by feeding back the charge pump output to the input of the charge pump to adjust the pump current. This is schematically illustrated in Figure 6 (in which like elements to those of Figure 1 are shown by like reference numerals), in which phase detector and charge pump 138 has an input to sense vtune, as well as a 256KHz reference frequency input and an input from PLL divider 136.

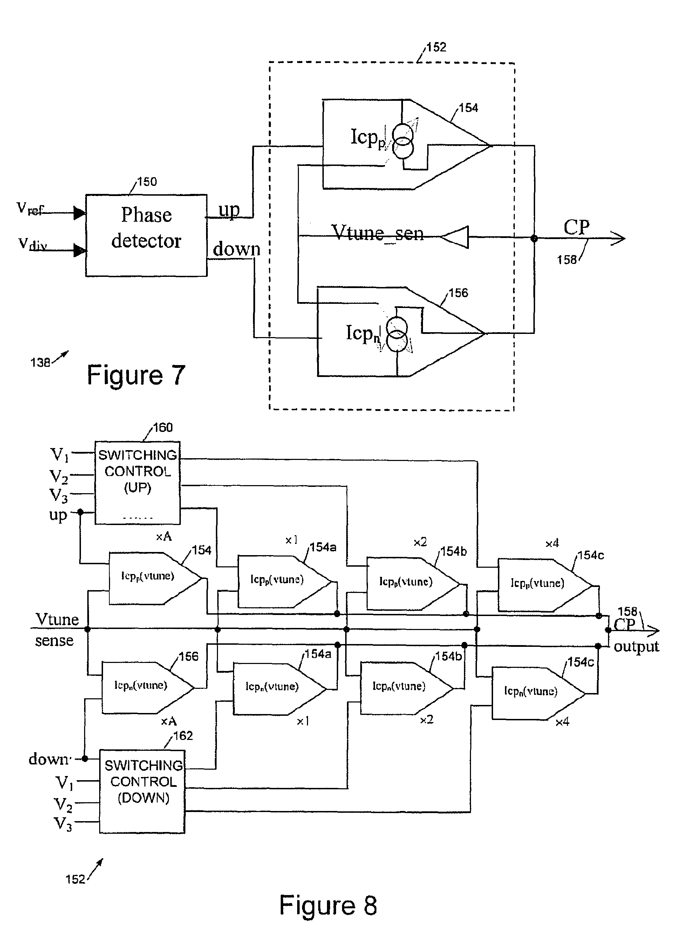

Figure 7 shows the phase detector and charge pump 138 in more detail. This comprises a phase detector 150 along the lines described above and a charge pump 152 comprising a pair of adjustable constant current generators, a constant current source 154 and a constant current sink 156 driven by respective "up" and "down" signals from phase detector 150 to produce pulses of current as required. Each of current source 154 and current sink 156 has a respective current adjust input, and both these current adjust inputs receive a (scaled) input from an output 158 of the charge pump. In this way the charge pump output varies with output voltage.

In operation the phase-frequency detector 150 compares the PLL divider output to the reference divider output, and, depending on the phase difference, sends an "up" or "down" pulse to enable a selected one of the two current sources of the charge pump. The combined output of the charge pump is connected to the external loop filter (to convert the output current pulse to an output voltage). The voltage at the output is fed back to the current sources and changes

their magnitudes, $Icp_p$ and $Icp_n$.

Referring now to figure 8, this shows a preferred embodiment of charge pump 152 which incorporates adjustment of the charge pump current output with VCO band-switch state. In figure 8 like elements to those of figure 7 are indicated by like reference numerals and thus the charge pump incorporates a pair of current sources 154, 156 as before, with feedback from the charge pump output 158, but additionally a set of three further pairs of (adjustable) current sources 154a, b, c; 156a, b, c (also with feedback) is employed to compensate for changes in VCO sensitivity with the selected band. The current sources 154a-c and sinks 156a-c are selected by respective control units 160, 162, which in turn receive inputs from the band-switching control signals $V_1$, $V_2$ and $V_3$. The current sources/sinks 154a, b, c, 156a, b, c are binary weighted and combined according to the band switching state, together with current generators 154, 156. For the highest band-switching state only current generators 154, 156 contribute to the charge pwnp output, and the output current is increased, by employing more of the current generators, the lower the band-switching state, to compensate for the reduced VCO sensitivity.

Referring back to figure 6 the operation of the VCO band switching controller 170 will now be described. In preferred embodiments the band-switching controller 170 is implemented using a simple voltage comparator that senses vtune and compares it to upper and lower limits. If vtune<$vtune_{min}$ for longer than a time $t_{delay}$ the band is switched to a lower state; if vtune>$vtune_{max}$ for longer than time $t_{delay}$, the band is switched to a higher state. The time $t_{delay}$ is chosen to inhibit oscillation of the synthesizer between states and so that band-switching is not triggered by changes in vtune of short duration.

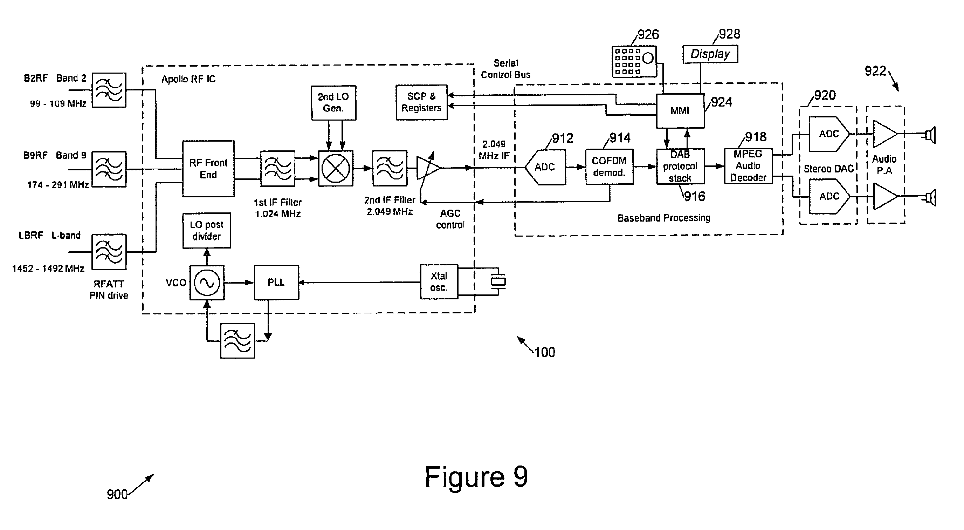

Figure 9 shows a block diagram of a complete DAB receiver 900 incorporating the radio receiver circuit of figure 1. In Figure 9 the IF output of the receiver circuit of figure 1 is provided to an analogue-to-digital converter 912 for digitisation and subsequent coded orthogonal frequency division multiplexed (COFDM) signal demodulation by COFDM demodulator block 914. The output of demodulator 914 is provided to a DAB protocol stack decoder 916, which in turn provides an MPEG datastream to MPEG audio decoder 918 which provides an audio output to stereo DAC 920 and audio amplifiers and speakers 922. A man machine interface (MMI) 924 interfaces with DAB protocol stack decoder 916 to provide a user keyboard 926 and display 928. These allow a user to interact with and control the receiver via the slave control processor and registers of receiver circuit 100.

No doubt many other effective alternatives will occur to the skilled person and it will be understood that the invention is not limited to the described embodiments but encompasses modifications apparent to those skilled in the art lying within the scope of the claims appended hereto.

## Claims

1.    A digital audio broadcast (DAB) receiver, the receiver comprising:

    an rf input to receive rf signals in at least two receive frequency bands;
    a local oscillator having a local oscillator signal output;
    a mixer having inputs coupled to said rf input and to said local oscillator and having an output to provide an IF frequency signal; and
    an output to provide an output signal from said IF frequency signal; and

    wherein
    said local oscillator comprises a phase locked loop (PLL) including a tunable voltage controlled oscillator (VCO) and a programmable divider coupled to an output of said voltage controlled oscillator to provide said local oscillator signal output;
    at least one of said two receive frequency bands being associated with a plurality of different division ratios of said programmable divider; wherein
    said voltage controlled oscillator (VCO) has a plurality of selectable VCO frequency bands; and wherein
    said local oscillator further comprises a VCO band selector to select a said VCO frequency band;
    whereby said at least two receive frequency bands are covered by said receiver by a combination of said VCO band selection and said plurality of different division ratios.

2.    A DAB receiver as claimed in claim 1 wherein said at least two receive frequency bands comprise a first frequency band comprising frequencies greater than 1 GHz and a second frequency band in the range 100MHz to 1GHz.

3.    A DAB receiver as claimed in claim 1 or 2 configured to further receive an FM (frequency modulation) broadcast in a third band by means of a combination of said VCO band selection and said plurality of different division ratios.

4. A DAB receiver as claimed in any one of claims 1 to 3 wherein said VCO comprises a junction varactor for tuning said VCO responsive to a control voltage, and a plurality of MOS varactors for selection of a said VCO frequency band.

5. A DAB receiver as claimed in claim 4 wherein said plurality of MOS varactors have binary weighted varactor areas.

6. A DAB receiver as claimed in claim 4 or 5 wherein said plurality of VCO frequency bands overlap.

7. A DAB receiver as claimed in any one of claims 1 to 6 wherein said PLL includes a phase detector; and wherein said phase detector has a gain which is varied dependent upon at least one of a tuning voltage of said VCO and a selected frequency band of said VCO.

8. A DAB receiver as claimed in claim 7 wherein said phase detector comprises a charge pump with an input from at least one of said VCO tuning voltage and a frequency band select signal for said VCO, and an output for controlling said VCO tuning voltage; said charge pump further including a feedback input coupled to said charge pump output for adjusting said charge pump output with said VCO tuning voltage.

9. A DAB receiver as claimed in claim 8 wherein said charge pump has an input for said VCO frequency band select signal to adjust said charge pump output responsive to a selected said frequency band.

10. A DAB receiver as claimed in claim 8 or 9 wherein said charge pump comprises at least one adjustable current generator to provide an output current responsive to at least one of said VCO tuning voltage and said VCO frequency band select signal.

11. A DAB receiver as claimed in any one of claims 1 to 3 wherein said VCO band selector is configured to compare a tuning control voltage for said VCO with a threshold and to adjust a selected VCO frequency band where said tuning control voltage is outside said threshold for greater than a delay time.

12. An integrated circuit comprising the DAB receiver of any preceding claim.

13. A local oscillator circuit for the DAB receiver of any preceding claim, said local oscillator circuit comprising a phase locked loop (PLL) including a tunable voltage controlled oscillator (VCO) and a programmable divider coupled to an output of said voltage controlled oscillator to provide said local oscillator signal output;
at least one of said two receive frequency bands being associated with a plurality of different division ratios of said programmable divider; wherein
said voltage controlled oscillator (VCO) has a plurality of selectable VCO frequency bands; and wherein
said local oscillator further comprises a VCO band selector to select a said VCO frequency band;
whereby said at least two receive frequency bands are covered by said receiver by a combination of said VCO band selection and said plurality of different division ratios.

**Patentansprüche**

1. Digitaler Audio-Rundfunkempfänger (DAB), umfassend:

    einen RF-Eingang zum Empfangen von RF-Signalen in mindestens zwei Empfangsfrequenzbändern;
    einen lokalen Oszillator mit einem lokalen Oszillatorsignalausgang;
    einen Mixer mit an den RF-Eingang und den lokalen Oszillator gekoppelten Eingängen und mit einem Ausgang zum Bereitstellen eines IF-Frequenzsignals ; und
    einen Ausgang zum Bereitstellen eines Ausgangssignals aus dem IF-Frequenzsignal; und

    wobei
    der lokale Oszillator einen Phasenregelkreis (PLL) umfasst, der einen abstimmbaren spannungsgesteuerten Oszillator (VCO) und einen an den spannungsgesteuerten Oszillator gekoppelten programmierbaren Frequenzteiler enthält, um den lokalen Oszillatorsignalausgang bereitzustellen;
    mindestens eins der beiden Empfangsfrequenzbänder mit einer Mehrzahl verschiedener Teilungsverhältnisse des programmierbaren Frequenzteilers assoziiert ist; wobei
    der spannungsgesteuerte Oszillator (VCO) eine Mehrzahl von auswählbaren VCO Frequenzbändern aufweist; und wobei

der lokale Oszillator ferner einen VCO Band Wahlschalter zur Auswahl eines VCO Frequenzbandes umfasst; wobei die mindestens zwei Empfangsfrequenzbänder von dem Empfänger durch eine Kombination von VCO Bandauswahl und Mehrzahl der verschiedenen Teilungsverhältnisse abgedeckt sind.

2. DAB Empfänger nach Anspruch 1, wobei die mindestens zwei Empfangsfrequenzbänder ein erstes Frequenzband mit Frequenzen, die größer als 1 GHz sind, und ein zweites Frequenzband im Bereich 100 MHz bis 1 GHz umfassen.

3. DAB Empfänger nach Anspruch 1 oder 2, der ferner darauf eingerichtet ist, ein FM Broadcast (Frequenzmodulation) in einem dritten Band mittels einer Kombination von VCO Bandauswahl und Mehrzahl der verschiedenen Teilungsverhältnisse zu empfangen.

4. DAB Empfänger nach einem der Ansprüche 1 bis 3, wobei der VCO eine Junction Varactor Diode zum Abstimmen des VCO in Reaktion auf eine Steuerspannung und eine Mehrzahl von MOS Varactor Dioden zur Auswahl eines VCO Frequenzbandes umfasst.

5. DAB Empfänger nach Anspruch 4, wobei die Mehrzahl der MOS Varactore binär gewichtete Varactor-Bereiche aufweisen.

6. DAB Empfänger nach Anspruch 4 oder 5, wobei sich die Mehrzahl der VCO Frequenzbänder überlappen.

7. DAB Empfänger nach einem der Ansprüche 1 bis 6, wobei der PLL einen Phasendetektor enthält; und wobei der Phasendetektor eine Verstärkung aufweist, die abhängig von mindestens einer Abstimmspannung des VCO und einem ausgewählten Frequenzband des VCO variiert wird.

8. DAB Empfänger nach Anspruch 7, wobei der Phasendetektor eine Ladepumpe mit einem Eingang für die mindestens eine VCO Abstimmspannung und ein Frequenzband-Auswahlsignal für den VCO sowie einen Ausgang zum Steuern der VCO Abstimmspannung umfasst; wobei die Ladepumpe ferner einen an den Ladepumpenausgang gekoppelten Rückkopplungseingang umfasst, um den Ladepumpenausgang mit Hilfe der VCO Abstimmspannung anzupassen.

9. DAB Empfänger nach Anspruch 8, wobei die Ladepumpe einen Eingang für das VCO Frequenzband-Auswahlsignal aufweist, um den Ladepumpenausgang in Reaktion auf ein ausgewähltes Frequenzband anzupassen.

10. DAB Empfänger nach Anspruch 8 oder 9, wobei die Ladepumpe mindestens einen anpassbaren Stromgenerator umfasst, um einen Ausgangsstrom in Reaktion auf die mindestens eine VCO Abstimmspannung und das VCO Frequenzband-Auswahlsignal bereitzustellen.

11. DAB Empfänger nach einem der Ansprüche 1 bis 3, wobei der VCO Band Wahlschalter darauf eingerichtet ist, eine Abstimm-Steuerspannung für den VCO mit einem Schwellenwert zu vergleichen und das ausgewählte VCO Frequenzband anzupassen, wobei die Abstimm-Steuerspannung um mehr als eine Verzögerungszeit außerhalb des Schwellenwerts liegt.

12. Integrierte Schaltung, umfassend einen DAB Empfänger nach einem der vorhergehenden Ansprüche.

13. Lokale Oszillatorschaltung für den DAB Empfänger nach einem der vorhergehenden Ansprüche, wobei die lokale Oszillatorschaltung einen Phasenregelkreis (PLL) mit einem abstimmbaren spannungsgesteuerten Oszillator (VCO) und einem an den spannungsgesteuerten Oszillator gekoppelten programmierbaren Frequenzteiler umfasst, um den lokalen Osizillatorsignalausgang bereitzustellen;
mindestens eins der zwei Empfangsfrequenzbänder mit einer Mehrzahl verschiedener Teilungsverhältnisse des programmierbaren Frequenzteilers assoziiert ist; wobei
der spannungsgesteuerte Oszillator (VCO) eine Mehrzahl von auswählbaren VCO Frequenzbändern aufweist; und wobei
der lokale Oszillator ferner einen VCO Band Wahlschalter zur Auswahl des VCO Frequenzbandes umfasst;
wobei die mindestens zwei Empfangsfrequenzbänder von dem Empfänger durch eine Kombination von VCO Bandauswahl und Mehrzahl der verschiedenen Teilungsverhältnisse abgedeckt sind.

**Revendications**

1. Récepteur de radiodiffusion numérique (DAB), le récepteur comprenant:

   une entrée rf pour recevoir des signaux rf dans au moins deux bandes de fréquences de réception;
   un oscillateur local comportant une sortie de signal d'oscillateur local;
   un mélangeur comportant des entrées couplées à ladite entrée rf et audit oscillateur local et comportant une sortie pour fournir un signal de fréquence IF; et
   une sortie pour fournir un signal de sortie à partir dudit signal de fréquence IF; et dans lequel:

   ledit oscillateur local comprend une boucle à verrouillage de phase (PLL) incluant un oscillateur commandé en tension (VCO) accordable et un diviseur programmable couplé à une sortie dudit oscillateur commandé en tension afin de fournir ladite sortie de signal d'oscillateur local,
   au moins l'une desdites deux bandes de fréquences de réception étant associée à une pluralité de différents rapports de diffusion dudit diviseur programmable; dans lequel:

   ledit oscillateur commandé en tension (VCO) comporte une pluralité de bandes de fréquences de VCO sélectionnables; et dans lequel:

   ledit oscillateur local comprend en outre un sélecteur de bande de VCO pour sélectionner une dite bande de fréquences de VCO,
   et ainsi, lesdites au moins deux bandes de fréquences de réception sont couvertes par ledit récepteur au moyen de ladite combinaison de ladite sélection de bande de VCO et de ladite pluralité de différents rapports de division.

2. Récepteur DAB selon la revendication 1, dans lequel lesdites au moins deux bandes de fréquences de réception comprennent une première bande de fréquences comprenant des fréquences supérieures à 1 GHz et une seconde bande de fréquences dans la plage de 100 MHz à 1 GHz.

3. Récepteur DAB selon la revendication 1 ou 2, configuré pour recevoir en outre une diffusion FM (modulation de fréquence) dans une troisième bande au moyen d'une combinaison de ladite sélection de bande de VCO et de ladite pluralité de différents rapports de division.

4. Récepteur DAB selon l'une quelconque des revendications 1 à 3, dans lequel ledit VCO comprend un varacteur de jonction pour accorder ledit VCO en réponse à une tension de commande, et une pluralité de varacteurs MOS pour la sélection d'une dite bande de fréquences de VCO.

5. Récepteur DAB selon la revendication 4, dans lequel ladite pluralité de varacteurs MOS comportent des zones de varacteur pondérées binaires.

6. Récepteur DAB selon la revendication 4 ou 5, dans lequel ladite pluralité de bandes de fréquences de VCO se chevauchent.

7. Récepteur DAB selon l'une quelconque des revendications 1 à 6, dans lequel ladite PLL inclut un détecteur de phase; et dans lequel ledit détecteur de phase présente un gain qui est modifié en fonction d'au moins (un élément pris parmi) une tension d'accord dudit VCO et une bande de fréquences sélectionnée dudit VCO.

8. Récepteur DAB selon la revendication 7, dans lequel ledit détecteur de phase comprend une pompe de charge comportant une entrée constituée par au moins (un élément pris parmi) ladite tension d'accord de VCO et un signal de sélection de bande de fréquences pour ledit VCO, et une sortie pour commander ladite tension d'accord de VCO; ladite pompe de charge incluant en outre une entrée de retour qui est couplée à ladite sortie de pompe de charge pour régler ladite sortie de pompe de charge à l'aide de ladite tension d'accord de VCO.

9. Récepteur DAB selon la revendication 8, dans lequel ladite pompe de charge comporte une entrée pour ledit signal de sélection de bande de fréquences de VCO afin de régler ladite sortie de pompe de charge en réponse à une dite bande de fréquences sélectionnée.

10. Récepteur DAB selon la revendication 8 ou 9, dans lequel ladite pompe de charge comprend au moins un générateur de courant réglable pour fournir un courant de sortie en réponse à au moins (un élément pris parmi) ladite tension d'accord de VCO et ledit signal de sélection de bande de fréquences de VCO.

**11.** Récepteur DAB selon l'une quelconque des revendications 1 à 3, dans lequel ledit sélecteur de bande de VCO est configuré pour comparer une tension de commande d'accord pour ledit VCO avec un seuil et pour ajuster une bande de fréquences de VCO sélectionnée où ladite tension de commande d'accord est à l'extérieur dudit seuil pendant plus longtemps qu'un temps de retard.

**12.** Circuit intégré comprenant le récepteur DAB selon l'une quelconque des revendications précédentes.

**13.** Circuit d'oscillateur local pour le récepteur DAB selon l'une quelconque des revendications précédentes, ledit circuit d'oscillateur local comprenant une boucle à verrouillage de phase (PLL) incluant un oscillateur commandé en tension (VCO) accordable et un diviseur programmable couplé à une sortie dudit oscillateur commandé en tension pour fournir ladite sortie de signal d'oscillateur local ;
au moins l'une desdites deux bandes de fréquences de réception étant associée à une pluralité de rapports de division différents dudit diviseur programmable ; dans lequel :

ledit oscillateur commandé en tension (VCO) comporte une pluralité de bandes de fréquences de VCO sélectionnables ; et dans lequel :

ledit oscillateur local comprend en outre un sélecteur de bande de VCO pour sélectionner une dite bande de fréquences de VCO,
et ainsi, lesdites au moins deux bandes de fréquences de réception sont couvertes par ledit récepteur au moyen d'une combinaison de ladite sélection de bande de VCO et de ladite pluralité de différents rapports de division.

Figure 1

Figure 2

Figure 3a

Figure 3b

Figure 4

Figure 5a

Figure 5b

Figure 6

Figure 7

Figure 8

Figure 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 896425 A

**Non-patent literature cited in the description**

- **ULRICH L. ROHDE ; DAVID P. NEWKIRK.** RF/Microwave Circuit design for Wireless Applications. Wiley-Interscience, 2000, 848-876